# EUROPEAN PATENT APPLICATION

(11) **EP 0 926 726 A1**
(43) Date of publication of application: **30.06.1999**
(21) Application number: 97830675.1
(22) Date of filing: 16.12.1997
(51) Int. Cl.: H01L 21/768, H01L 23/48

(54) **Fabrication process and electronic device having front-back through contacts for bonding onto boards**

(71) Applicant: STMicroelectronics S.r.l., 20041 Agrate Brianza (Milano) (IT)
(72) Inventor: Mastermatteo, Ubaldo, Via Brera, 18/c (IT); Murari, Bruno, Via Ardigo, 1 (IT)
(74) Representative: Cerbaro, Elena

(57) **Abstract**

The integrated electronic device (35) is intended for bonding to a motherboard (36) of dimensions much larger than the device. The device comprises a substrate (3') of semiconductor material; an insulating and protective layer (11, 25) above the substrate, housing electrical connection structures inside it; a solid through contact (20) extending through the substrate (3), connected to the electrical connection structure and having a lower end projecting from the substrate (3') for connection to tracks (37) of the board (35). The substrate (3') initially has a thickness much greater than the length of the through contact (20) and is reduced in thickness by lapping after bonding the front surface to a support wafer (30) and before separating the individual devices.

## Description

The invention relates to a fabrication process and an electronic device having front-back through contacts for bonding onto boards of dimensions much larger than the electronic device.

As is known, contacting of micro-integrated electronic devices requires forming contact pads on the front of the wafer in which components forming the electronic devices are integrated and connecting the contact pads to the external connection pins by means of bonding wires.

It is also known that the continuous reduction of dimensions and the corresponding increase in components that can be integrated in the same chip involve an increase in the number of pins and the corresponding contact pads required for the external connection of the chip.

Consequently, the space required for the interconnections becomes an increasingly large fraction of the area of the chip. To avoid this problem, the actual dimensions of the bonding pads and the space between them would have to reduce; there are, however, limiting factors (minimum dimensions of the bonding wire; mechanical tolerances of alignment of the wires on the pads) which cause the minimum dimensions of the pads to be areas not much less than 100 x 100 µ². These dimensions are particularly large if compared to the minimum lithographic dimensions, of the order of tenths of a micron.

It is therefore desirable to have contact areas available in also different areas of the device, such as on the back; on the other hand this is not easy to achieve because of the need to insulate the connections from the device conductive regions and to produce reliable electrical connections between the front of the device, on which electrical metal connection run, and the back, on which pads would be arranged, using operations and materials compatible with conventional process steps.

The object of the invention is therefore to provide a process that enables through contacts to be produced for connection between the wafer front and contact pads located on the wafer back, to allow bonding of the devices to motherboards.

The invention provides a fabrication process and an electronic device having front-back through contacts for bonding to boards, as defined in Claims 1 and 17 respectively.

For an understanding of the invention, preferred embodiments will now be described, purely by way of non-exhaustive example, with reference to the accompanying drawings in which:
- Figures 1-9 show cross-sections through semiconductor material wafer in successive steps of a first embodiment of the process according to the invention;
- Figure 10 shows a perspective view of mounting integrated devices according to the invention on a motherboard of much larger dimensions;
- Figures 11-15 show cross-sections through a semiconductor material wafer in successive steps of a second embodiment of the process according to the invention;
- Figure 16 shows a transverse perspective section through a wafer of semiconductor material in a fabrication step of a third embodiment of the process according to the invention; and
- Figures 17 and 18 show cross-sections in successive fabrication steps of the third embodiment of Figure 16.

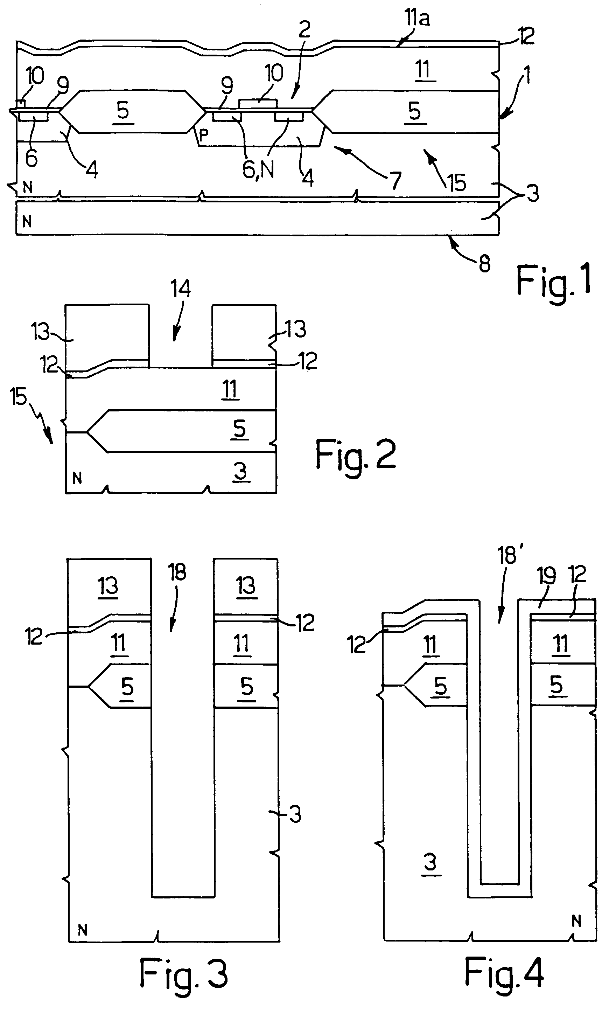

In Figure 1, a wafer 1 of semiconductor material (silicon), 600-700 µm thick for example, has been subjected to known fabrication steps for forming micro-electronic components; in particular, in the example shown, MOS transistors 2 are shown in a surface region 7 of wafer 1. In detail, Figure 1 shows a substrate 3 of a first conductivity type, N for example, which may comprise either a single crystal grown in a single step or regions grown successively by epitaxial growth; substrate 3 has a lower surface 8 that houses wells 4 of a second conductivity type, P-type in the present case; field insulating regions 5 have been grown astride the surface of the substrate 3; N-type source/drain conductive regions 6 have been produced inside the wells 4; on top of the surface of the substrate 3, a gate oxide layer 9 has been grown, gate regions 10 of multi-crystal silicon have been formed and a dielectric layer 11 (BPSG - Boron Phosphorous Silicon Glass for example) which defines an upper surface 11a of the wafer has been deposited.

According to Figure 1, a service layer 12 of multi-crystal silicon is deposited on top of dielectric layer 11, before opening the contacts for the components produced in wafer 1; a photoresist mask, denoted by 13 in Figure 2, is then produced, having an opening 14 on top of a drill region 15 of wafer 1 in which a through contact (plug) is to be formed. Conveniently, drill region 15 is selected to comprise a field oxide region 5, reliably to guarantee isolation of the plug. Using mask 13, first the uncovered portion (facing opening 14) of service layer 12 is removed, obtaining the intermediate structure of Figure 2, then dielectric layer 11, field oxide region 5 and substrate 3 are etched, obtaining the intermediate structure of Figure 3 in which a blind hole 18 formed in wafer 1 can be seen. Etching is preferably carried out as dry etching, using a high-frequency plasma etching machine normally used to produce deep trenches in single-crystal silicon wafers. The etching section, preferably of circular form, must be sufficiently large to allow coating of the walls of hole 18 with oxide and subsequently filling the coated hole with conductive material. For example, it has been found that a diameter of 10 µm may be sufficient for this purpose. The hole is produced with a depth of 30 µm for example.

Resist mask 13 is then removed and an oxide is deposited from ozone; an insulating layer 19 of silicon oxide approx. 2 µm thick thus covers lateral and lower walls of the hole that thus reduces to approx. 6 µm in diameter and is denoted by 18'. Insulating layer 19 also covers the upper surface of the wafer. Alternatively insulating layer 19 may also be grown thermally, at the expense of the single-crystal silicon forming substrate 3.

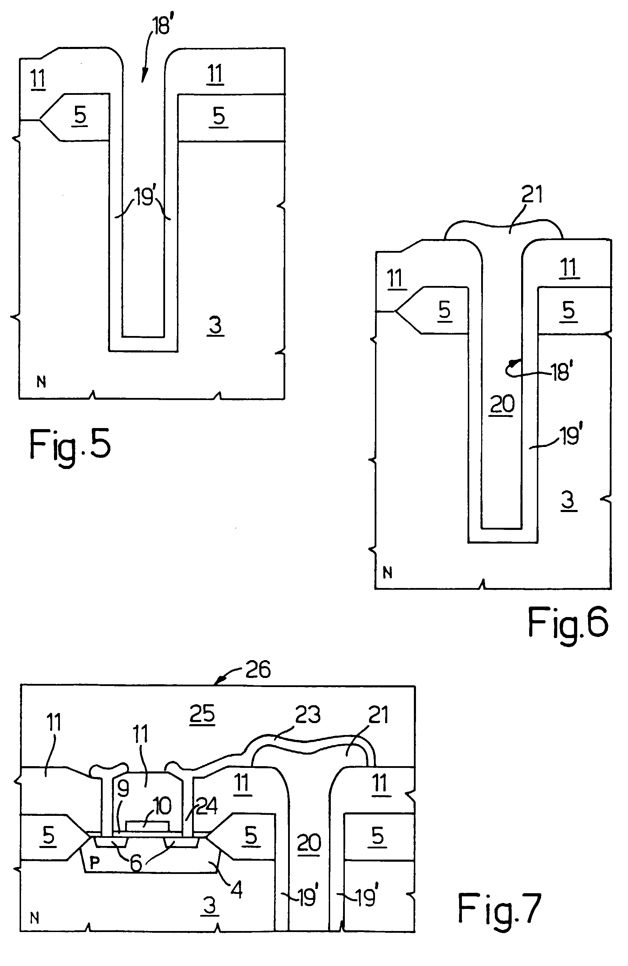

The intermediate structure of Figure 4 is obtained in this way. An anisotropic etching step is then carried out to remove a surface portion of insulating layer 19 extending on top of service layer 12, without substantially removing the oxide from the vertical walls and the bottom of hole 18'. This etching is selective with respect to silicon and is automatically interrupted when service layer 12 is reached. A cleaning etching step is then carried out, which is selective with respect to oxide, and enables service layer 12 to be completely removed, leaving dielectric layer 11 and the insulating layer (now denoted by 19') on the walls of hole 18' unchanged, as shown in Figure 5.

Plugs are then produced, by filling hole 18' with electrically conducting material such as copper. Filling is preferably carried out in two different steps, such as a first wet electroless deposition step (or copper deposited by CVD, Chemical Vapour Deposition) to promote adhesion and uniform covering of the walls of hole 18', and a second growth step by electroplating, still of copper, so as to obtain rapid growth. Alternatively to the above the metal deposited by CVD may be aluminium or tungsten and the second metallic layer may be electroless or galvanic nickel.

When the step of forming the plugs is completed, hole 18' is filled with conductive material that also extends over the surface of dielectric layer 11 and, inside hole 18', forms a plug 20. The metallic material on top of dielectric layer 11 is then removed by an appropriate masking and chemical etching step, providing the structure of Figure 6 in which plug 20 provided with an enlarged head 21 projecting from hole 18' can be seen.

Conventional machining steps of the front side of the wafer 1 follow, including opening the contacts, depositing the first metal layer and its shaping, providing the structure of Figure 7, in which a metal line 23 extends from head 21 of the plug on top of dielectric layer 11 and through it (portion 24) as far as one of regions 6, so as electrically to connect plug 20 to region 6. In particular, if wet etching is provided in the contact opening step, prior to this a masking step is necessary to cover head 21 of the plug and prevent contact of the material of plug 20 with the etching solution which could be contaminated; alternatively, a completely dry etching technique can be used.

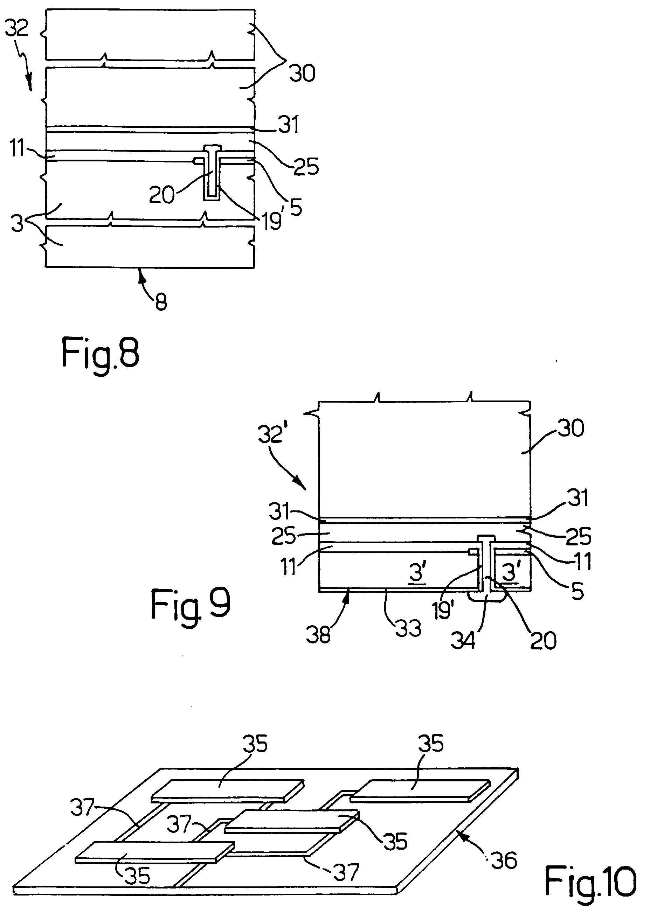

The process continues with subsequent steps including optional forming a second and third metal level and depositing a passivation layer 25, providing the intermediate structure of Figure 7. Wafer 1 is then bonded to the front (surface 26 of passivation layer 25) to a support wafer 30 using a double adhesive layer (stick foil) 31 formed by inert heat-resistant resin (Figure 9, on a smaller scale than Figures 1-7, in which transistors 2 and metal layers have not been shown for reasons of simplicity). A double wafer, denoted in its entirety by 32, is thus obtained. Double wafer 32 is then thinned: in particular, back of wafer 1 is subjected to lapping to reduce the thickness of wafer 1 as far as the lower end of plugs 20; consequently, the substrate (now denoted by 3') has a final thickness substantially equal to the length of through contact 20 or to the depth of hole 18 less the thickness of insulating layer 19 (equal to 30-2 = 28 µm in the example in question). Optionally, when lapping is completed, substrate 3' may be chemically etched so that the bottom end of plug 20 projects slightly from substrate 3'. A thinned wafer 32' (Figure 9, again on reduced scale) is thus obtained, the lower surface 38 of which is covered by an oxide layer 33, apart from the point at which the plugs 20 project; bumps 34 of gold-plated nickel are then produced, in known manner, at the bottom end of plugs 20, as shown in Figure 9.

Finally, thinned wafer 32' is cut into dices 35 and, optionally after having been subjected to final tests, it is bonded to a motherboard 36 equipped with aluminium tracks 37 for electrical connection to the pads formed by bumps 34 (Figure 10).

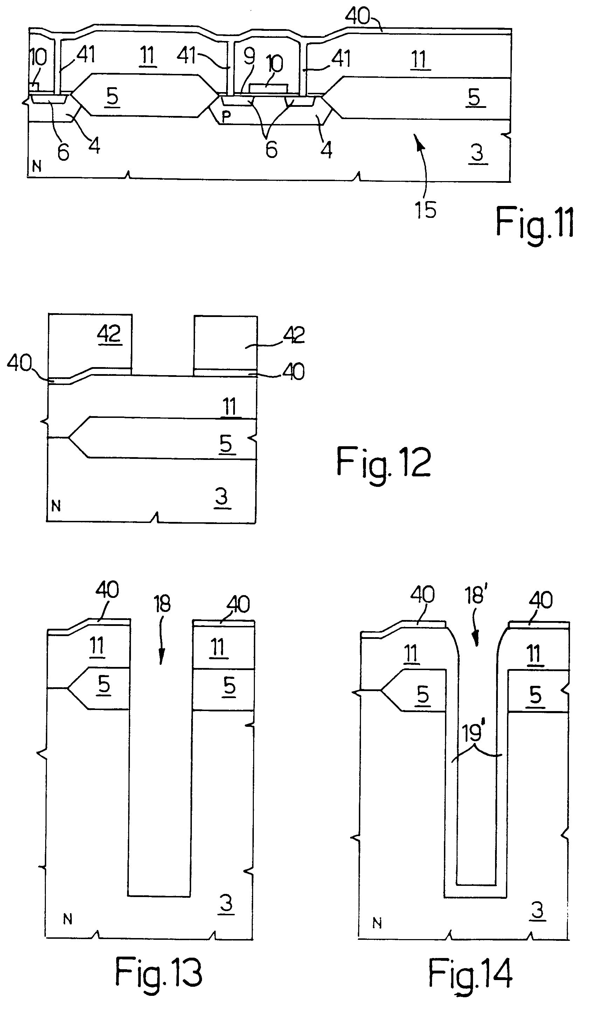

In the variant according to Figures 11-15, the plug is produced after forming the electrodes and the metal connection lines of the integrated device. In particular, in Figures 11-15, a process with a single metal level has been considered, but the steps described below are also applicable to processes with two and three metal levels, after depositing the second or third level, provided that the thermal or TEOS-applied oxide layer succeeds in completely covering the walls of hole 18.

Figure 11 shows an intermediate structure similar to that of Figure 1 except that service layer 12 has not been deposited, contacts have already been opened inside dielectric layer 11 and the first metal level has already been deposited (or the second, in case of a process with two levels and for producing the plug after depositing the second level). Consequently, a metallic layer 40, of aluminium for example, having portions 41 extending through dielectric layer 11, at openings previously produced, for electrical contact with conductive regions of component 2, extends on top of dielectric layer 11.

A mask 42 that covers the entire free surface of wafer 1, apart from the zone or zones in which holes are to be produced, is then deposited; then, using mask 42, first uncovered portion of metal layer 40 (Figure 12) and then of underlying dielectric layer 11, field oxide layer 5 and part of substrate 3 is etched and removed in a manner similar to that described above with reference to Figures 2 and 3. After removal of mask 42, the intermediate structure of Figure 13 is thus obtained, in which hole 18 can be seen. Alternatively, the metal layer 40 may screen etching of the underlying layers, after removal of mask 42, still providing the structure of Figure 13.

In a manner similar to the above described with reference to Figures 4 and 5, the insulating layer covering lateral and lower walls of hole 18 and metal layer 40 is then deposited; the insulating layer is then etched anisotropically to remove it completely from on top of metallic layer 40, obtaining the structure of Figure 14.

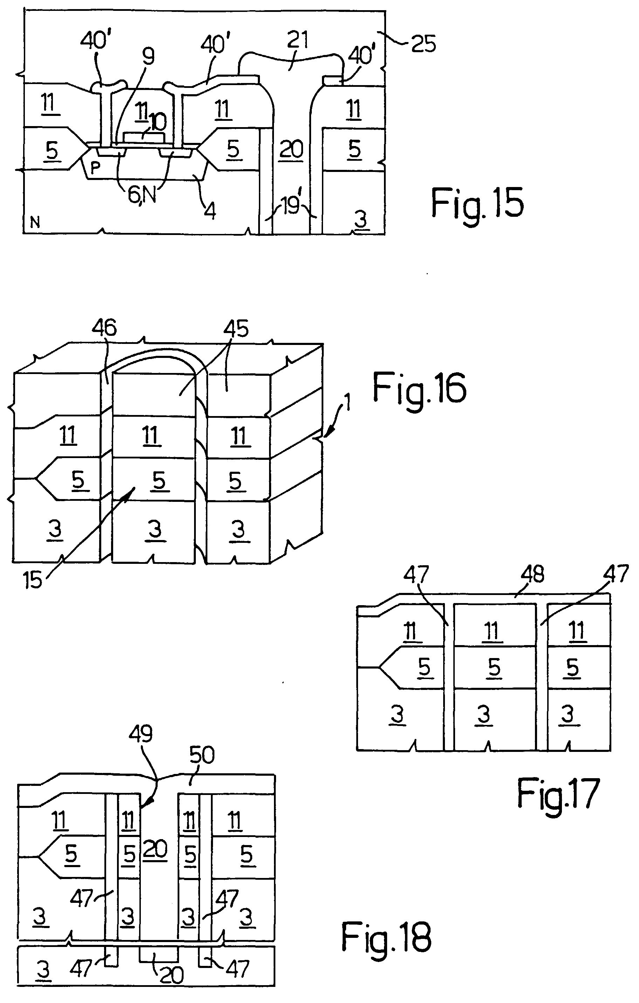

Subsequently, in a manner similar to that described with reference to Figure 6, plug 20 is produced by electroless deposition of copper and subsequent growth of copper by electroplating; the metal layer is then shaped to leave only the body of plug 20, which completely fills hole 18', and enlarged head 21, projecting from the hole. In particular, as can be seen from Figure 15, enlarged head 21 extends in part on top of metal layer 40, producing electrical contact between plug 20 and metal layer 40. Metal layer 40 is then defined, according to the layout, optional further metal levels are produced and finally passivation layer 25, which covers the entire upper surface, is deposited, obtaining the structure of Figure 15.

Subsequent steps described above then follow, including bonding to a support wafer 30, lapping, depositing the insulating oxide layer 33; forming bumps 34; cutting into dices 35 and bonding to a motherboard 36, as described for Figures 9 and 10.

Figures 16-18 show a third embodiment in which electrical isolation of plug 20 with respect to substrate 3 is obtained by producing an oxide cylinder outside the hole in which the plug is to be produced. In detail, with reference to Figure 16 that is a perspective view for greater clarity, after depositing dielectric layer 11 on top of wafer 1 and before opening the contacts and depositing the first metal layer, a cylindrical excavation is carried out, using a mask 45. A trench 46 of cylindrical shape is thus obtained, which is less wide than hole 18 and has an internal diameter greater than the diameter of the plug; the depth of trench 46 is also at least equal (preferably slightly larger, for safety reasons) to that of the plug.

Subsequently, after removing mask 45, an oxide layer is grown or deposited which comprises a cylindrical region 47 completely filling trench 46 and a surface region 48 extending on top of dielectric layer 11, providing the intermediate structure of Figure 17. Surface region 48 is then removed by anisotropic etching, as described above, and, by means of a further mask, not shown, the hole for the plug is produced inside the region of wafer 1 surrounded laterally by cylindrical region 47. In this case, the hole (denoted by 49 in Figure 18) may have a smaller diameter than hole 18, given that it is destined to be filled solely with the conductive material of the plug. After removing the mask for producing hole 49, the metal material of the plug is then deposited and/or grown, as described above, forming plug 20 and a metal layer 50 extending over the surface of dielectric layer 11. The steps already described for the first embodiment, including removing metal layer 50 apart from enlarged head 21 of the plug, then follow, as do the subsequent steps as far as bonding the individual devices to motherboard 36.

This third embodiment has the advantage with respect to the preceding ones of having wider margins as far as bumps are concerned.

The advantages of the described method and device are as follows. First, they enable pads to be produced on back of the device, requiring on the front only a zone of reduced dimensions in which enlarged head 21 is present. In fact, with an enlarged head 21 of a radius of 8 µm, the area occupied on the device front is approximately 400 µm² compared with typical dimensions of approx. 6400 µm² in current integrated devices. Furthermore, the process does not require any modification to the fabrication steps known for each device, but only the addition of steps of drilling and producing the through metal connections. Producing the metal contact when production of the components is complete ensures that the components will not be damaged; producing the insulating layer 19' coating the hole or the cylindrical region 47 further ensures electrical isolation of through contact 20 from substrate 3'.

Finally, it will be clear that many modifications and variants may be introduced to the method and device described and illustrated herein, all of which come within the scope of the invention as defined in the accompanying claims.

## Claims

1. A process for fabricating an electronic device formed in a body (1) comprising regions of semiconductor material (4, 5, 10) and regions of insulating material (5, 9, 11), said body (1) having an upper surface (11a) and a surface zone (7) close to said upper surface and housing electronic components (2), characterized in that it comprises the steps of:
- producing a blind hole (18; 49) in a drill region (15) of said body (1), said blind hole extending starting from said upper surface (11a);
- forming an insulating region (19'; 47) of electrically insulating material, extending in said drill region (15) laterally to said blind hole (18; 49);
- forming a through contact (20) of conductive material filling said blind hole;
- forming an electrical connection structure (23; 40') extending on top of said upper surface (11a) between and in electrical contact with said through contact (20) and said electronic component (2);
- removing a lower portion of said body (1) at least as far as a lower wall of said through contact (20) and forming a lower bonding surface (38);
- forming contact regions (34) on said lower bonding surface (38) at said through contact (20).

2. A process according to Claim 1, characterized in that said step of forming an insulating region (19') comprises the step of forming a hole insulating layer (19) laterally covering walls of said blind hole (18).

3. A process according to Claim 2, characterized in that said step of forming a hole insulating layer comprises the step of depositing or growing said hole insulating layer (19).

4. A process according to Claim 3, characterized in that said body (1) comprises an upper dielectric layer (11) defining said upper surface (11a); in that the step of depositing a service layer (12), of material resistant to etching of said electrically insulating material, is carried out before said step of depositing said hole insulating layer (19); in that after said step of depositing a hole insulating layer (19) the steps of anisotropic etching and removing surface portions of said hole insulating layer are carried out, in a manner screened by said service layer (12), and successively removing said service layer.

5. A process according to Claim 1, characterized in that said step of forming an insulating region (47) comprises the steps of forming a trench (46) extending annularly in said body (1) in a position outside said hole (49); and filling said trench with said electrically insulating material.

6. A process according to Claim 5, characterized in that said step of forming an insulating region (47) is carried out before said step of producing a blind hole (49).

7. A process according to any one of the preceding Claims, characterized in that said electrically insulating material is silicon oxide.

8. A process according to any one of the preceding Claims, characterized in that said step of forming a through contact (20) comprises the step of depositing a metal contact layer.

9. A process according to Claim 7, characterized in that said step of depositing a metal contact layer is followed by a step of growing metal material by electroplating.

10. A process according to Claim 9, characterized in that said metal material is copper.

11. A process according to any one of the preceding Claims, characterized in that said step of producing an electrical connection structure (23) is carried out after said step of forming a through contact (20) and said connection structure comprises connection lines (23) electrically connecting said through contact to conductivity regions (6) of said electronic components (2).

12. A process according to any one of Claims 1-4, 7-10, characterized in that said step of producing a connection structure (40') is carried out before said step of forming a through contact (20) and comprises the steps of: forming a conductive connection layer (40) completely covering said upper surface (11) and having portions (41) extending as far as conductivity regions (6) of said electronic components (2); in that said step of forming a through contact comprises the step of producing a plug (20) having an enlarged head (21) extending on top of and in electrical contact with said conductive connection layer (40) and in that the step of shaping said conductive connection layer (40) is carried out after said step of forming a through contact.

13. A process according to any one of the preceding Claims, characterized in that said step of removing a lower portion comprises the step of lapping of said body (1).

14. A process according to any one of the preceding Claims, characterized in that the steps of forming a protective layer (25) on top of said body (1) and bonding said protective layer to a support wafer (30) are carried out before said step of removing a lower portion.

15. A process according to any one of the preceding Claims, characterized in that said step of forming contact regions (34) comprises the step of producing a lower insulating layer (33) on said lower bonding surface (38); selectively removing said lower insulating layer (33) at said through contact (22) and producing a conductive projection (34) in contact with said through contact and extending partially on top of said lower insulating layer (38).

16. A process according to any one of the preceding Claims, characterized in that the steps of cutting said body (1) into a plurality of electronic devices (35) and bonding said devices to motherboards (36) of dimensions much larger than said devices are carried out after said step of forming contact regions (34).

17. An integrated electronic device (35) for bonding to a motherboard (36) of dimensions much larger than said device, comprising a substrate (3) of semiconductor material housing conductivity regions (4, 6); an insulating and protective layer (11, 25) above said substrate and housing electrical connection structures (23; 40') inside it; characterized in that it comprises at least one solid through contact (20) extending through said substrate (3) and at least part of said insulating and protective layer (11, 25); said through contact (20) having a first end (21) extending in said insulating and protective layer and in direct electrical contact with at least one electrical connection structure (23; 40') and a second end projecting from said substrate (3).

18. A device according to Claim 17, characterized in that it comprises a support portion (30) bonded to said insulating and protective layer (11, 25).

19. A device according to Claim 17 or 18, characterized in that said substrate (3) has a lower surface (38) covered by a lower insulating layer (33), said lower insulating layer having openings at said through contacts (20).

20. A device according to any one of Claims 17-19, characterized in that it comprises an annular region (19'; 47) of electrically insulating material surrounding said through contact (20).

21. A device according to Claim 20, characterized in that said annular region (19') is arranged immediately adjacent to said through contact (20).

22. A device according to Claim 20, characterized in that said annular region (47) is arranged laterally spaced from said through contact (20).
